## Europäisches Patentamt
## European Patent Office
## Office européen des brevets

(11) Publication number: **0 072 378**
**B1**

(12) # EUROPEAN PATENT SPECIFICATION

(45) Date of publication of patent specification: **23.11.89**

(51) Int. Cl.⁴: **G 11 B 7/26, G 03 F 7/16**

(21) Application number: **81303630.8**

(22) Date of filing: **07.08.81**

(54) Method relating to disc forming.

(30) Priority: **11.08.80 US 176743**

(43) Date of publication of application:
**23.02.83 Bulletin 83/08**

(45) Publication of the grant of the patent:
**23.11.89 Bulletin 89/47**

(84) Designated Contracting States:
**AT BE CH DE FR GB IT LI LU NL SE**

(56) References cited:
**EP-A-0 026 081**
**DE-A-2 443 108**
**DE-B-2 554 692**
**US-A-4 267 212**

**Optics and Laser Technology, August 1977,
p.169-1**

(73) Proprietor: **DISCOVISION ASSOCIATES
P.O. Box 6600 3300 Hyland Avenue
Costa Mesa California 92626 (US)**

(72) Inventor: **Wilkinson, Richard L.
21341 Avenida Manantial
E. Toro California 92630 (US)**

(74) Representative: **Raynor, John et al
W.H. Beck, Greener & Co 7 Stone Buildings
Lincoln's Inn
London WC2A 3SZ (GB)**

Courier Press, Leamington Spa, England.

EP 0 072 378 B1

# Description

This invention relates generally to methods for forming video discs or digital music discs, or computer record discs.

Optically-readable video and like, disc replicas are useful in storing vast quantities of information, usually in the form of a frequency-modulated (f.m.) carrier signal, with a high recording density. The f.m. signal is typically recorded as a sequence of spaced pits or bumps arranged in a succession of substantially circular and concentric turns of a recording track. Each pit and adjacent space between pits represents one cycle of the f.m. signal.

Disc replicas are typically formed in injection-moulding apparatus using disc-shaped stampers derived from recording masters. A recording master typically includes a glass substrate having a disc shaped, planar surface, with a think recording layer such as a metal film overlaying it. Information is normally recorded in the recording layer by focusing an intensity-modulated writing beam of light onto the layer using a radially-movable objective lens, as the matter is rotated at a prescribed rate. The intensity of the beam is modulated in accordance with the f.m. signal to be alternately greater than and less than a predetermined threshold at which the metal film is melted, whereby the succession of spaced pits is formed in the film. The succession of pits and spaces preferably has a nominal duty cycle of 50/50, whereby the signal is recorded with minimum second harmonic distortion.

In the manufacture of discs it may be necessary to apply to a disc substrate a layer of uniform thickness, for example a layer of photo-resist material, or a layer of a material for preparing a disc or a layer of a developer material.

According to the invention, there is provided a method for developing an exposed photo-resist layer of a prescribed, uniform thickness on an optical information disc matter, comprising steps of: rotating the disc master at a first prescribed velocity; selecting a photoresist developer solution having a prescribed normality; pre-wetting the layer; dispensing both water and the developer solution simultaneously upon the photoresist layer; rinsing the developed photoresist layer with water to eliminate residual developer solution from the layer; and subsequently rotating the disc master at a second higher prescribed velocity to dry the developed photoresist layer, characterised in that the pre-wetting is by dispensing water unaccompanied by developer solution on the photoresist layer of the rotating master; in that the photoresist layer is only partially developed during the simultaneous dispensation of water and developer solution; and in that completion of development of the layer is achieved in a second development stage in which developer solution alone is dispensed on the photoresist layer.

The exposed photoresist layer is developed by dispensing onto the layer, while it is rotating at the relatively low velocity (e.g. 75 to 100 r.p.m.) first water, to pre-wet the layer, then both water and a developer solution of a prescribed normality, to partially develop the layer, and finally developer solution, alone, to fully develop the layer. The developed photoresist layer is then rinsed with water, to eliminate residual developer solution, and finally rotated at the relatively high velocity of preferably 750 to 1000 r.p.m., to dry the developer layer. The photoresist layer is preferably derived from Shipley AZ 1350 photoresist (Shipley AZ 1350 is a Trade Mark) and the developer solution is preferably either potassium hydroxide or sodium hydroxide, with a normality of about 0.230 to 0.240. The step of dispensing both water and developer solution preferably has a time duration of about 5 to 10 seconds, the step of dispensing developer solution alone preferably has a time duration of about 20 seconds, and the steps of rinsing preferably has a time duration of about 30 to 60 seconds.

In the production of a video disc master, a glass substrate may initially be prepared by dispensing an adhesion promoter such as stannous chloride onto the surface of the substrate while the substrate is rotated at a relatively low velocity, e.g. about 75 to 100 r.p.m. The surface may then be rinsed with water while still being rotated at the relatively slow velocity, thereby removing residual adhesion promoter, after which the rinsed surface is dried by being rotated at a relatively high velocity, e.g. about 750 to 1000 r.p.m.

The method for preparing the substrate can further include preliminary steps of polishing the surface using a polishing compound having a submicron particle size, and then cleaning the polished surface.

The cleaning step can include steps of flushing the surface first with a detergent solution and then with water, drying the surface by rotating the substrate at the relatively high velocity, and wiping the surface with acetone to remove traces of dust and oil.

The photoresist recording layer may be applied to the prepared surface of the glass substrate by dispensing a photoresist solution onto the surface as the substrate is being rotated at the relatively low velocity, by then rotating the substrate at the relatively high velocity to partially dry the photoresist solution and form a layer having a substantially uniform thickness, and by finally baking the photoresist-coated substrate in a prescribed fashion to completely dry the photoresist layer. The photoresist solution is preferably Shipley AZ 1350 photoresist having a velocity of about 1.3 centipoise and in the step of baking, the master is preferably baked at about 80 degrees centigrade for about 20 minutes.

A thin metal layer may be formed on the glass substrate prior to the application of the photosensitive recording layer.

The invention may be carried into practice in various ways, and certain methods embodying it will now be described by way of example with reference to the accompanying drawings;

Figure 1 is a simplified schematic diagram of apparatus for recording an f.m. information signal on a recording master produced in accordance with the methods of the present invention.

Figure 2 is a perspective view of a turntable apparatus used in forming the photoresist recording layer on the recording master of Figure 1.

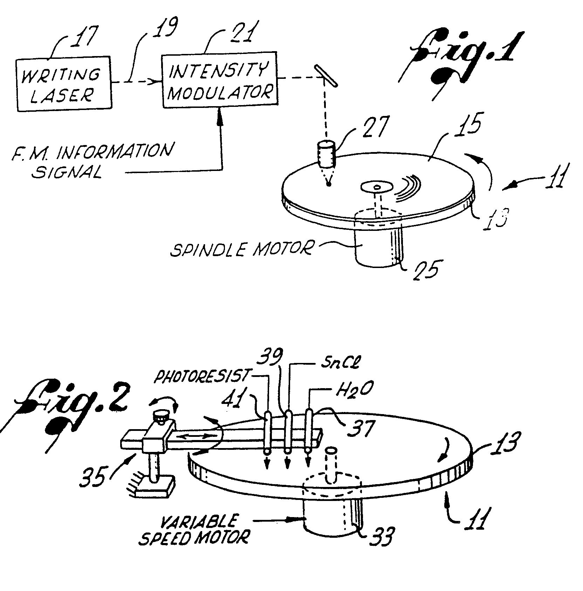

Referring now to the drawings, and particularly to Figure 1, there is shown apparatus for recording a frequency-modulated (f.m.) information signal on a recording master 11. The master includes a glass substrate 13, with a smooth, planar upper surface on which is deposited a photoresist layer 15 having a prescribed, uniform thickness. The photoresist layer is exposed whenever impinged by a beam of light having an intensity that exceeds a predetermined recording threshold.

The recording apparatus includes a writing laser 17 such as an argon ion laser for producing a writing beam of light 19 having a prescribed intensity, and an intensity modulator 21 for modulating the intensity of the writing beam in accordance with an f.m. information signal. The recording apparatus further includes a spindle motor 25 for rotating the recording master 11 at a prescribed angular velocity, and an objective lens 27 for focusing the intensity-modulated beam onto the photoresist layer 15 of the rotating master. The objective lens is mounted on a carriage (not shown) that is radially movable with respect to the master, so that the focused beam traces a spiral pattern on the photoresist layer.

The intensity of the intensity-modulated beam 19 is alternately greater than and less than the predetermined recording threshold of the photoresist layer 15, whereby a succession of spaced exposed regions arranged in a plurality of substantially circular and concentric recording tracks is formed in the layer.

A photoresist layer for use in the method of the invention may be prepared as follows. The upper surface of a glass substrate 13 is first ground and polished, and then cleaned. The photoresist layer 15 is then formed by dispensing a photoresist solution onto the surface, after which it is dried and baked in a prescribed fashion. After baking, the recording master is in suitable condition for recording. If desired, a thin metal layer may be formed on the substrate prior to forming the photosensitive layer.

More particularly, the planar surface of the glass substrate 13 is initially prepared by first grinding it in a conventional manner, using an aluminum oxide compound having about an nine-micron grit. The surface is then polished using a zirconium oxide or cerium oxide polishing compound of sub-micron particle size. Cerium oxide has been found to polish the surface more quickly, but is generally more difficult to clean.

The polished surface of the glass substrate 13 is cleaned in a special three-step process. First, the surface is flushed with high-purity, de-ionized water and brushed with a fine brush to remove most of the polishing compound. The de-ionized water preferably has a resistivity of 18 mega-ohms centimeter. The cleaned surface of the glass substrate 13 is thereafter inspected by light. Under this light, defects such as scratched and microscopic pits appear as point sources of scattered light. When a defect is detected, a microscope is used to measure its size. If any defects larger than 25 microns are detected, or if the number of defects under 10 microns exceed one per square millimeter, the substrate is rejected and the polishing and cleaning sequences are repeated. The surface is then wiped with acetone to remove any traces of dust and oil introduced during handling.

Second, the surface is flushed with a detergent solution, and third, the surface is again flushed with de-ionized water for a period of about ten to twenty minutes.

After cleaning, the substrate 13 is placed on a turntable, as shown in Figure 2 and rotated at an angular velocity of about 750-1000 r.p.m., to dry the surface. Figure 6 depicts apparatus for use in forming the photoresist layer 15 on the cleaned substrate 13. The apparatus includes a variable speed motor 33 for rotating the substrate in a prescribed fashion, and a pivot arm 35 on which are mounted three dispensing tubes 37, 39 and 41 for dispensing de-ionzied water, a stannous chloride solution, and a photoresist solution, respectively, in a prescribed sequence.

The substrate 13 is first rotated at an angular velocity of about 75 to 100 r.p.m., while stannous chloride is dispensed onto the cleaned upper surface through the dispensing tube 39. The pivot arm 35 is pivoted manually so that stannous chloride is applied to the entire surface. It is believed that the stannous chloride molecules adhere to the cleaned surface of the substrate, and thereby promote a subsequent adhesion of the photoresist solution.

Water is then dispensed onto the surface through the dispensing tube 37, to rinse off residual stannous chloride solution, and the angular velocity of the motor 33 is then increased to about 750-1000 r.p.m., to dry the rinsed surface. The surface is now in proper condition for dispensing of the photoresist solution.

The photoresist solution is prepared by diluting Shipley AZ 1350 photoresist with Shipley AZ thinner, which is believed to include ethyleneglycolmonomethylether acetate, in a ratio of about 3 to 1 (Shipley AZ 1350 and Shipley AZ are Trade Marks). This provides a solution having a viscosity of about 1.3 centipoise, which is then filtered to remove particles larger than about one half micron. Viscosity can be measured by standard techniques, such as, for example, using a Canon-Finske viscometer.

The diluted photoresist solution is then dispensed through the tube 41 onto the prepared surface of the substrate 13, as the substrate is being rotated by the variable speed motor 33 at an angular velocity of about 75-100 r.p.m. Again, the pivot arm 35 is pivoted manually so that the solution is dispensed across the entire radius of the substrate. At the speeds below about 75 r.p.m., a film of substantially uniform thickness can be achieved only if a relatively lengthy spread time is allowed but this increases the likelihood of contamination of the layer. At speeds above about 100 r.p.m., on the other hand, radial streaks and flow marks can result, affecting the quality of the subsequent recording of information. About 35 ml of photoresist solution are required to fully coat a substrate having a diameter of about 35.56 cm.

After the photoresist solution has been coated onto the surface of the substrate 13, the angular velocity of the motor 33 is increased to about 750-1000 r.p.m., until dry. This provides a prescribed, uniform thickness for the photoresist layer 15.

After removal from the turntable apparatus of Figure 2, the recording master 11 is baked, to fully dry the photoresist layer 15 and thereby maximize its exposure tolerance. The master is preferably baked at about 80° centigrade for about 20 minutes. These parameters must be maintained to a tight tolerance, to minimize variations in exposure tolerances when successively recording information on a number of recording masters.

Using the recording apparatus of Figure 1, with the peak intensity of the writing beam 19 adjusted to the prescribed, optimum value, the f.m. information signal is then recorded on the photoresist recording layer 15. The recorded master 11 is then developed to convert each recording track into a succession of spaced pits of uniform depth and width and of continuously-variable length.

The exposed recording master 11 is then developed in the process in accordance with the invention in which a succession of fluids are dispensed onto the master as it is being rotated by a turntable of the type depicted in Figure 2, at a velocity of about 75 to 100 r.p.m. In the process, water is first dispensed to pre-wet the layer, then both water and a developer solution of prescribed normality are dispensed to partially develop the layer, and finally developer solution, alone is dispensed, to fully develop the layer. The developed photoresist layer is then rinsed with water, to remove residual developer solution, after which the angular velocity of the rotating master is increased to about 750-1000 r.p.m. to dry the developed layer.

The preferred developer solution is potassium hydroxide or sodium hydroxide and has a normality of about 0.230 to 0.240. Preferably, the step of dispensing both water and developer solution has a duration of about 5 to 10 seconds, the step of dispensing developer solution alone, about 20 seconds, and the step of rinsing about 30 to 60 seconds.

A stamper, suitable for use in moulding video disc replicas, may be produced from the developed recording master 11 by first vapour depositing a uniform metallic film of about 50-60 nm thickness onto the photoresist recording layer 15, and then electroplating a second uniform metallic film of about 0,38 mm (15 mils) thickness onto the first film. The undersurface of the first film conforms exactly to the pattern of spaced pits formed in the photoresist layer, and the two films together form an interal metallic layer. This integral metallic layer can be separated from the underlying recording master and residual photoresist material removed using a suitable photoresist thinner, thereby forming the stamper. In the preferred embodiment, both metallic films are formed of nickel. Metallic stampers are produced from these recording masters for use in moulding replicas of the master.

**Claims**

1. A method for developing an exposed photoresist layer of a prescribed, uniform thickness on an optical information disc master, comprising steps of: rotating the disc master at a first prescribed velocity; selecting a photoresist developer solution having a prescribed normality; pre-wetting the layer; dispensing both water and the developer solution simultaneously upon the photoresist layer; rinsing the developed photoresist layer with water to eliminate residual developer solution from the layer; and subsequently rotating the disc master at a second higher prescribed velocity to dry the developed photoresist layer, characterised in that the pre-wetting is by dispensing water unaccompanied by developer solution on the photoresist layer of the rotating master; in that the photoresist layer is only partially developed during the simultaneous dispensation of water and developer solution; and in that completion of development of the layer is achieved in a second development stage in which developer solution alone is dispensed on the photoresist layer.

2. A method as defined in Claim 1, wherein: the photoresist developer solution is potassium hydroxide or sodium hydroxide.

3. A method as defined in Claim 2, wherein the photoresist developer solution is selected to have a normality in the range of about 0.230 to about 0.240.

4. A method as defined in any preceding claim, wherein: the first prescribed velocity is in the range of about 75 rpm to about 100 rpm; and the second prescribed velocity is in the range of about 750 rpm to about 1000 rpm.

5. A method as claimed in any preceding claim in which the duration of each of the steps during which developer solution and water or developer solution alone are dispensed on the photoresist layer is timed.

6. A method as defined in Claim 5, wherein: the step of dispensing both water and the developer solution has a time duration in the range of about 5 seconds to about 10 seconds.

7. A method as claimed in Claim 5 or Claim 6 in which the step of dispensing developer solution, alone, has a time duration of about 20 seconds.

8. A method as claimed in any of Claims 5 to 7 in which the step of rinsing has a time duration in the range of about 30 seconds to about 60 seconds.

## Patentansprüche

1. Verfahren zur Entwicklung einer belichteten Lichtschutzdeckmittelschicht von vorgeschriebener, gleichförmiger Dicke auf einer optische Informationen aufnehmenden Plattenmatrize mit den Schritten, die Plattenmatrize mit einer ersten vorgeschriebenen Geschwindigkeit umlaufen zu lassen, eine Entwicklerlösung für das Lichtschutzdeckmittel mit einer vorgeschriebenen Normalität auszuwählen, die Schicht vorzubefeuchten, sowohl Wasser als auch die Entwicklerlösung gleichzeitig auf der Lichtschutzdeckmittelschicht zu verteilen, die entwikkelte Lichtschutzdeckmittelschicht mit Wasser abzuspülen, um von der Schicht Entwickler-Lösungsreste zu beseitigen, und anschließend zum Trocknen der entwickelten Lichtschutzdeckmittelschicht die Plattenmatrize mit einer zweiten höheren, vorgeschriebenen Geschwindigkeit umlaufen zu lassen, dadurch gekennzeichnet, daß das Vorbefeuchten in der Weise vorgenommen wird, daß auf der Lichtschutzdeckmittelschicht der umlaufenden Matrize Wasser ohne Zusatz von Entwicklerlösung verteilt wird, daß während der gleichzeitigen Verteilung von Wasser und Entwicklerlösung die Lichtschutzdeckmittelschicht nur teilweise entwickelt wird, und daß ein Abschluß einer Entwicklung der Schicht in einer zweiten Entwicklungsstufe erreicht wird, in der Entwicklerlösung allein auf der Lichtschutzdeckmittelschicht verteilt wird.

2. Verfahren, wie im Anspruch 1 definiert, bei dem die Entwicklerlösung des Lichtschutzdeckmittels Kaliumhydroxid oder Natriumhydroxid ist.

3. Verfahren, wie im Anspruch 2 definiert, bei dem die Entwicklerlösung des Lichtschutzdeckmittels so ausgewählt wird, daß sie eine Normalität in dem Bereich von etwa 0,230 bis etwa 0,240 aufweist.

4. Verfahren, wie in einem vorhergehenden Anspruch definiert, bei dem die erste vorgeschriebene Geschwindigkeit in dem Bereich von etwa 75 Umdrehungen je Minute bis etwa 100 Umdrehungen je Minute und die zweite vorgeschriebene Geschwindigkeit in dem Bereich von etwa 750 Umdrehungen je Minute bis etwa 1000 Umdrehungen je Minute liegt.

5. Verfahren, wie in irgendeinem vorhergehenden Anspruch beansprucht, bei dem die Dauer jedes der Schritte, während der eine Entwicklerlösung und Wasser oder Entwicklerlösung allein auf der Lichtschutzdeckmittelschicht verteilt werden, zeitlich bemessen wird.

6. Verfahren, wie im Anspruch 5 definiert, bei dem der Schritt einer Verteilung sowohl von Wasser als auch von der Entwicklerlösung sich über eine Zeitspanne in dem Bereich von etwa 5 Sekunden bis 10 Sekunden erstreckt.

7. Verfahren, wie im Anspruch 5 oder Anspruch 6 beansprucht, bei dem sich der Schritt, Entwicklerlösung allein zu verteilen, über eine Zeitspanne von etwa 20 Sekunden erstreckt.

8. Verfahren, wie in einem der Ansprüche 5 bis 7 beansprucht, bei dem der Schritt des Abspülens sich über eine Zeitspanne in dem Bereich von etwa 30 Sekunden bis etwa 60 Sekunden erstreckt.

## Revendications

1. Procédé pour développer une couche d'agent photo-résistant exposée d'une épaisseur uniforme prédéterminée sur un disque père d'information optique; comprenant les étapes de: faire tourner le disque père à une première vitesse prédéterminée; choisir une solution de révélateur d'agent photo-résistant ayant une normalité prédéterminée; pré-humecter la couche; amener à la fois l'eau et la solution de révélateur simultanément sur la couche d'agent photo-résistant; rincer la couche d'agent photo-résistant développée à l'eau pour éliminer la solution de révélateur résiduelle de la couche; et ensuite faire tourner le disque père à une seconde vitesse plus élevée prédéterminée pour sécher la couche d'agent photo-résistant développée; caractérisé en ce que le pré-mouillage se fait en amenant de l'eau non accompagnée de solution de révélateur sur la couche d'agent photo-résistant du disque père en rotation; en ce que la couche d'agent photo-résistant est seulement partiellement développée au cours de l'apport simultané d'eau et de solution de révélateur; et en ce que le développement de la couche est achevé dans une seconde étape de développement dans laquelle la solution de révélateur seule est amenée sur la couche d'agent photor-ésistant.

2. Procédé selon la revendication 1, dans lequel: la solution de révélateur d'agent photo-résistant est de l'hydroxyde de potassium ou de l'hydroxyde de sodium.

3. Procédé selon la revendication 2, dans lequel la solution de révélateur d'agent photo-résistant est choisie pour avoir une normalité dans la gamme d'environ 0,230 à environ 0,240.

4. Procédé selon l'une des revendications précédentes, dans lequel la première vitesse prédéterminée est dans la gamme d'environ 75 t/mn à environ 100 t/mn; et la seconde vitesse prédéterminée est dans la gamme d'environ 750 t/mn à environ 1000 t/mn.

5. Procédé selon l'une des revendications précédentes, dans lequel la durée de chacune des étapes au cours desquelles la solution de révélateur et l'eau ou la solution de révélateur seule sont amenées sur la couche d'agent photo-résistant est minutée.

6. Procédé selon la revendication 5, dans lequel: l'étape d'amener à la fois l'eau et la solution de révélateur a une durée dans la gamme d'environ 5 secondes à environ 10 secondes.

7. Procédé selon la revendication 5 ou la revendication 6, dans lequel l'étape d'amener la solution de révélateur seule a une durée d'environ 20 secondes.

8. Procédé selon l'une des revendications 5 à 7, dans lequel l'étape de rinçage a une durée dans la gamme d'environ 30 secondes à environ 60 secondes.

EP 0 072 378 B1

*Fig.1*

*Fig.2*